Europäisches Patentamt

European Patent Office

Office européen des brevets

(11) Publication number: **0 241 237 B1**

# EUROPEAN PATENT SPECIFICATION

(45) Date of publication of patent specification: **23.12.92**

(51) Int. Cl.⁵: **H01L 31/10,** H01L 31/02, G01T 1/29

(21) Application number: **87302912.8**

(22) Date of filing: **03.04.87**

(54) **Device including a radiation sensor.**

(30) Priority: **11.04.86 US 850977**

(43) Date of publication of application:
**14.10.87 Bulletin  87/42**

(45) Publication of the grant of the patent:
**23.12.92 Bulletin  92/52**

(84) Designated Contracting States:
**BE DE ES FR GB IT NL SE**

(56) References cited:

**IEEE TRANSACTIONS ON NUCLEAR SCIENCE, vol. 33, no. 1, February 1986, pages 351-354, IEEE, New York, US; S.N. KAPLAN et al.: "Detection of charged particles in amorphous silicon layers"**

**PATENT ABSTRACTS OF JAPAN, vol. 6, no. 258 (P-163)[1136], 17th December 1982; & JP-A-57 154 083**

(73) Proprietor: **AMERICAN TELEPHONE AND TELEGRAPH COMPANY**
**550 Madison Avenue**
**New York, NY 10022(US)**

(72) Inventor: **Bethea, Clyde G.**
**943 Hillside Avenue**
**Plainfield New Jersey 07062(US)**
Inventor: **Brasen, Daniel**
**5 New England Drive**
**Lake Hiawatha New Jersey 07034(US)**
Inventor: **Levine, Barry Franklin**
**22 Bear Brook Lane**
**Livingston New Jersey 07930(US)**
Inventor: **Willens, Ronald Howard**
**7 Wychwood Way**
**Warren New Jersey 07060(US)**

(74) Representative: **Johnston, Kenneth Graham et al**
**AT&T (UK) Ltd. 5 Mornington Road**
**Woodford Green Essex, IG8 OTU(GB)**

**IEEE JOURNAL OF SOLID STATE CIRCUITS,**
**vol. SC-13, no. 3, June 1978, pages 392-399,**
**IEEE, New York, US; G.P. PETERSSON et al.:**
**"Position sensitive light detectors with high**
**linearity"**

**APPLIED PHYSICS LETTERS, vol. 49 no. 22,**
**1st December 1986, pages 1537-1539, Ameri-**
**can Institute of Physics, New York, US; B.F.**
**LEVINE et al.: "Lateral photoeffect in thin**
**amorphous superlattice films of Si and Ti**
**grown on a Si substrate"**

**APPLIED PHYSICS LETTERS, vol. 49, no. 11,**
**15th September 1986, pages 663-665, Ameri-**
**can Institute of Physics, New York, US; R.H.**
**WILLENS: "Photoelectronic and electronic**
**properties of Ti/Si amorphous superlattices"**

## Description

### Technical Field

The invention is concerned with devices including a radiation sensor or detector, for example of electromagnetic or particle radiation.

### Background of the Invention

Depending on the type of radiation, and depending further on the specific radiation attribute to be monitored, a great variety of radiation sensors and detectors have been developed for electromagnetic as well as for particle radiation; see, e.g.,

R. J. Keyes, ed., Optical and Infrared Detectors, Springer-Verlag, 1977 and

E. Kowalski, Nuclear Electronics, Springer-Verlag, 1970.

Sensors and detectors are widely applicable as incorporated in a variety of devices for use in fields such as, e.g., instrumentation, communications, and robotics; with respect to robotics and related fields, position sensing applications are considered as particularly significant. Commercially available position-sensitive photodetectors are based on the photoelectric effect of the p-n junction, typically as implemented in the form of a silicon device. In this respect see, e.g.,

B. Schmidt et al., "Position-sensitive Photodetectors Made with Standard Silicon-planar Technology", Sensors and Actuators, Vol. 4 (1983), pp. 439-446.

P-n junction sensors are based on a physical phenomenon known as Wallmark effect or, more descriptively, as lateral photovoltaic effect; such effect consists in the appearance of a voltage parallel to a p-n junction when such junction is irradiated nonuniformly. For further detail and discussion of the lateral photovoltaic effect see, e.g.,

G. P. Petersson et al., "Position-sensitive Light Detectors with High Linearity", IEEE Journal of Solid-state Circuits, Vol. SC-13 (1978), pp. 392-399 and

H. Niu et al., "Application of Lateral Photovoltaic Effect to the Measurement of the Physical Quantities of P-N Junctions - Sheet Resistivity and Junction Conductance of $H_2^+$-implanted Si", Japanese Journal of Applied Physics, Vol. 15 (1976), pp. 601-609.

While satisfactory p-n junction devices are readily made so long as their dimensions do not exceed a few micrometers, larger-size devices are difficult to make sufficiently uniform. Furthermore, when such devices are intended for position sensing, it has been found difficult to produce a voltage response which is sufficiently linear as a function of the position of a beam. Accordingly, there is demand for photodetectors and radiation sensors having an essentially linear response to the position of incident radiation.

### Summary of the Invention

Radiation-induced electrical effects have been discovered in layered structures of conductor and semiconductor materials such as, e.g., structures of alternating layers of titanium and silicon. Resulting structures are suitable as sensors and detectors of electromagnetic radiation, and these structures are sensitive also to particle radiation such as, e.g., a beam of alpha particles. Resulting sensors, in turn, are suitable for inclusion in a variety of devices like, e.g., position sensors and digital-to-analog converters.

### Brief Description of the Drawing

FIG. 1 schematically and in cross section shows a radiation intensity sensor device in accordance with the invention;

FIG. 2 schematically and in cross section shows a position sensor device in accordance with the invention;

FIG. 3 schematically and in plan view shows an alternate position sensor device in accordance with the invention, having a highly nonlinear voltage response as a function of incident beam position; and

FIG. 4 schematically and in cross section shows a digital-to-analog converter device in accordance with the invention.

### Detailed Description

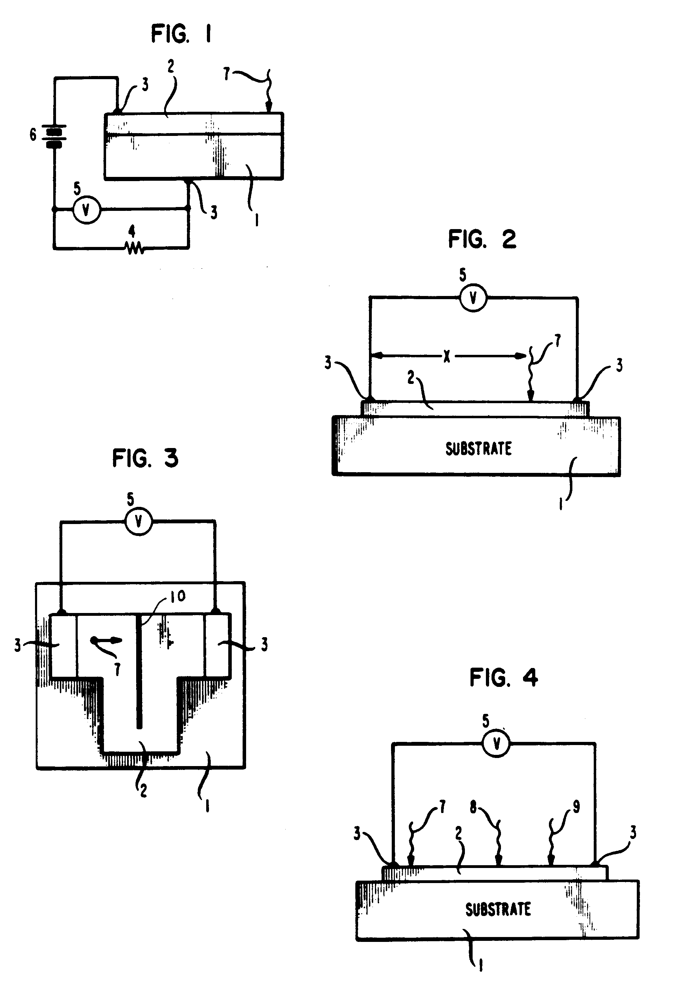

Shown in FIG. 1 are substrate 1, film 2 of alternating metallic and semiconductor layers, contacts 3, resistor 4, voltmeter 5, and optional bias potential source 6. When irradiated with electromagnetic or particle radiation 7, voltage across resistor 4 varies as a function of radiation intensity. A bias potential can be used to affect sensitivity of a device; sensitivity increases as a bias voltage is applied in the same direction as the photovoltage and, conversely, an opposing bias voltage reduces sensitivity.

Shown in FIG. 2 are substrate 1, film 2 of alternating metallic and semiconductor layers, contacts 3, and voltmeter 5. When irradiated with radiation 7, voltage between contacts 3 varies as a function of the position, x, of the incident beam. Typically, if a single, x-dimension is to be determined, film 2 is made in the form of a narrow strip which may be rectilinear or curved depending on the path of a light beam. Accordingly, such a device can be used as a transducer for the measurement of position, velocity, acceleration, rotation, strain, temperature, and other scalar-valued quantities. Furthermore, by making a film not as a strip but as covering an area, and by suitable choice of electrodes, 2-dimensional data such as, e.g., x-y-position can be sensed by a resulting device.

Shown in FIG. 3 are substrate 1, film 2 of alternating metallic and semiconductor layers, electrical contacts 3 to the top surface of film 2, and voltmeter 5. As a spot of incidence of radiation 7 moves across a narrow gap 10 in the film, voltage between contacts 3 changes abruptly from an initial polarity to the opposite polarity.

By suitable choice of film geometry it is further possible to combine characteristics of devices in accordance with FIG. 2 and FIG. 3. Resulting devices exhibit low sensitivity for beam positions far from the gap and increased sensitivity as a beam approaches the gap.

Shown in FIG. 4 are substrate 1, film 2 of alternating metallic and semiconductor layers, contacts 3, and voltmeter 5. Three beams of incident radiation 7, 8, and 9 are shown as corresponding to digital input values such that the presence of beam 7 corresponds to a digital value of 4, the presence of beam 8 to a digital value of 1, and the presence of beam 9 to a digital value of 2. (Absence of a beam indicates a corresponding value of 0.) Output voltage measured between contacts 3 is an analog representation of the sum of digital information provided in the form of beams of radiation.

Devices of the invention are sensitive to electromagnetic radiation such as, typically, optical, ultraviolet, or infrared radiation. Also, devices are sensitive to particle radiation such as, e.g., electrons, protons, and alpha particles.

Structures of alternating layers in accordance with the invention can be deposited on insulating substrates or, preferably, on n-or p-type semiconductor substrates; semiconductor substrates are preferred in view of enhanced radiation-induced electrical effects on account of the substrate serving as a pump.

When a substrate material is sufficiently transparent to radiation of interest, incidence of radiation may be through the substrate, such incidence being facilitated in view of direct electrical contact to the layered structure in the absence of a back-electrode. This aspect of the invention is of particular interest for infrared detectors on silicon substrates. Furthermore, absence of contacts to semiconductor substrates is of particular significance where the attachment of contacts would require special care as, e.g., in the case of III-V and II-VI semiconductor materials. Specific examples in this respect are gallium arsenide and mercury-cadmium telluride semiconductor substrates.

Semiconducting layers such as, e.g., layers of silicon, germanium, or silicon-germanium typically are deposited in amorphous form and having convenient thickness in a preferred range of from 0.1 to 10 nanometers Semiconductor materials may be p-doped, n-doped, or undoped.

Metallic or conductor layers may be elemental or alloyed, such materials here being defined conveniently in terms of their bulk resistivity of less than 200 micro-ohm-cm. (Bulk resistivity of insulator and semiconductor materials is understood to be greater than 10000 micro-ohm-cm.) Essentially pure titanium is considered to be particularly suitable as a metallic layer material, and zirconium and niobium may be similarly recommended. Preferably, metallic layers are in essentially amorphous form, such form being realized at preferred layer thicknesses which are less than 8 and preferably less than 5 nanometers. For the sake of ease of deposition of continuous layers, thickness of all layers preferably is at least 0.1 nanometer. The number of periods of alternating layers is typically up to 500. Most conveniently, a structure of alternating layers consists of just two types of materials - one metallic and the other semiconducting; however, variation of the composition of such layers is not precluded.

Photoelectric effects observed in accordance with the invention may be accounted for theoretically in terms of the following description. For a structure of alternating layers on a p-substrate and with locally incident light, radiation absorbed in the substrate produces hole-electron pairs. Electrons in the depletion region, within the minority diffusion length, are swept into the film of alternating layers by the Schottky field. Charge separation cancels a portion of the space charge, and this, in turn, reduces the internal barrier potential. The reverse Schottky leakage current, consisting of electrons moving back to the p-region, brings the barrier to an equilibrium configuration by adjusting the local barrier potential so that the rates of photo-generation and recombination are equal.

In the substrate a lateral photovoltage is produced as a result of the separation process of the holes and electrons and the reduction of the barrier potential at the point of incident radiation. Holes in the substrate move laterally under the influence of this gradient in potential. In the metallic film, the lateral driving force for flow of the electrons is attributed to diffusion due to their concentration gradient. A potential gradient develops as the electrons diffuse through the resistive film.

The lateral flows of electrons and holes cancel a portion of the barrier space charge laterally along the junction, and this would result in increased recombination of electrons and holes laterally across the junction if it were not for the high degree of anisotropy of the structure of alternating layers. As a result, the transverse Schottky current is likely to be controlled by transport through multiple layers by thermionic emission and/or diffusion, resulting in a high-grade Schottky junction with recombination not controlled by the initial interface states of the substrate.

Example 1.

Alternating layers of titanium and silicon were deposited by electron-beam evaporation on a p-type, 50-ohm-cm silicon substrate having an impurity concentration of approximately $2 \times 10^{14}/cm^3$. During deposition the substrate temperature was in the vicinity of 5 degrees C, and deposition was in a vacuum having a residual atmosphere consisting essentially of hydrogen at a partial pressure of approximately $10^{-8}$ torr (or, approximately $133 \times 10^{-8}$ Pa). Deposition rate was approximately 0.1 nanometer/sec. Individual layers of titanium and silicon had approximate respective thicknesses of 0.6 nanometer and 1.3 nanometer, and a strip consisting of 264 periods of alternating titanium and silicon layers was deposited on an area measuring approximately 20 mm by 2 mm. Ohmic contacts in the form of silver paint were applied to the ends of the strip.

The strip was locally irradiated with laser radiation from a helium-neon laser at a wavelength of approximately 0.63 micrometer, and photovoltage was observed as a function of radiation intensity. Photovoltage increased as a function of intensity, and the increase was essentially linear over a significant domain of intensities.

Example 2.

A layered structure was deposited as described in Example 1 above except that the structure had 20 periods, the width of the strip was approximately 1 mm, and the length of the strip was approximately 16 mm. Lateral photovoltage as a function of position of an irradited spot on the strip was determined by means of laser radiation produced by a low-power helium-neon laser. Lateral photovoltage was found to vary essentially linearly, between zero upon irradiation near an endpoint and approximately 10 mV upon irradiation near the midpoint of the strip. (Deviation from linearity was less than 4 percent.) The photocurrent was measured also, and excellent linearity of current as a function of beam position was observed.

Example 3.

A device which acts as a high-sensitivity position detector was made by scratching a layered structure which had been deposited as described in Example 1 above over an area measuring approximately 20 by 20 mm. Contacts were provided as schematically shown in FIG. 3. When the film was irradiated to the left of the scratch, output voltage was approximately 80 mV; as the beam was moved across the scratch, output voltage dropped abruptly to -80mV.

Example 4.

A device which acts as a digital-to-analog converter was made by depositing, as described above in Example 1, a strip 25 mm long and 2 mm wide and having 10 periods of alternating titanium and aluminum. Three sources of gallium arsenide laser radiation were used as schematically shown in FIG. 4, and the following respective approximate output voltages were found for the eight possible digital values, 1, 2, 3, 4, 5, 6, 7, and 0 corresponding to on-off combinations of the three beams: 5 mV, 10 mV, 15 mV, -20mV, -15mV, -10mV, -5 mV, and 0 mV.

Example 5.

A layered structure was deposited as described in Example 1 above except that the structure had 10 periods, the width of the strip was approximately 2 mm, and the length of the strip was approximately 15 mm. The structure was irradiated locally with radiation whose wavelength was varied from 0.7 to 1.1 micrometer. For wavelengths from 0.7 to approximately 0.95 micrometer, lateral photovoltage was found to be directly related to wavelength; as wavelength was increased further, smooth voltage drop-off was observed.

**Claims**

1. A radiation sensitive device which comprises a substrate, a layered structure upon the substrate and a pair of electrical contacts to the device, at least one of said contacts being to the layered structure, said layered structure consisting of a plurality of pairs of layers in succession from the substrate, the material of one layer in each pair being different from the material of the other layer of the pair, CHARACTERIZED IN THAT said substrate is of a material selected from an insulator and n-type or p-type semiconductor materials, said one layer of each pair is of a semiconductor material selected from n-type, p-type and undoped semiconductor materials, and has a thickness in the range of 0.1 to 10 nanometers, and said other layer of each pair is of a metallic conductor material with bulk resistivity of less than 200 micro-ohm-cm, and has a thickness in the range of 0.1 to 8 nanometers

2. Device according to claim 1, CHARACTERIZED IN THAT the semiconductor material in each of said one layer is the same or different in different pairs, and the metallic conductor material in each of said other layer is the same or different in different pairs.

3. The device according to claim 1 or 2, CHARACTERISED IN THAT the layered structure includes up to 500 pairs of layers in succession from the substrate.

4. Device according to claim 1 or 2 or 3 CHARACTERIZED IN THAT said metallic conductor material is selected from titanium, zirconium and niobium.

5. Device according to any one of preceding claims 1-4, CHARACTERIZED IN THAT the semiconductor material in the layered structure is selected from materials of Group IV, Group III-Group V and Group II-Group IV materials.

6. Device according to claim 5, CHARACTERIZED IN THAT the Group IV material is selected from silicon, germanium and silicon-germanium.

7. Device according to claim 1 or 2 or 3 CHARACTERIZED IN THAT the semiconductor material in the layered structure is silicon, and the metallic conductor material is titanium.

8. Device according to any one of preceding claims 1-7, CHARACTERIZED IN THAT said electrical contacts are to the same face of the layered structure.

9. Device according to any one of preceding claims 1-8, CHARACTERIZED IN THAT said element serves as a radiation intensity sensor or as a position sensor, or a highly linear position sensor, or as a highly nonlinear position sensor, or as a sensor of electromagnetic radiation, or as a sensor of particle radiation, or any suitable combination thereof.

10. A method of producing a device according to any one of preceding claims 1-9, CHARACTERIZED BY depositing on said substrate said plurality of alternating layers of metallic conductor and semiconductor materials, at a relatively low temperature.

**Patentansprüche**

1. Strahlungsempfindliches Bauelement, umfassend:
   - ein Substrat,
   - einen Schichtaufbau auf dem Substrat und
   - ein Paar elektrischer Kontakte zu dem Bauelement, wobei zumindest einer der Kontakte zu dem Schichtaufbau führt, welcher aus mehreren Schichtpaaren, sukzessiv von dem Substrat ausgehend, besteht, wobei das Material einer Schicht in jedem Paar sich von dem Material der anderen Schicht in dem Paar unterscheidet,
   dadurch gekennzeichnet, daß
   - das Substrat aus einem Material besteht, welches aus einem Isolator und n-leitenden oder p-leitenden Halbleitermaterialien ausgewählt ist,
   - die eine Schicht jeden Paares aus einem Halbleitermaterial besteht, welches aus n-leitenden, p-leitenden oder undotierten Halbleitermaterialien ausgewählt ist und eine Dicke im Bereich von 0,1 bis 10 Nanometer aufweist, und
   - die andere Schicht des Paares aus einem metallischen Leitermaterial besteht, dessen spezifischer Widerstand im massiven Material weniger als 200 Mikro-Ohm-cm beträgt, und das eine Dicke im Bereich von 0,1 bis 8 Nanometer aufweist.

2. Bauelement nach Anspruch 1, dadurch gekennzeichnet, daß das Halbleitermaterial in jeder der einen Schichten das gleiche oder unterschiedlich in verschiedenen Paaren ist, und das metallische Leitermaterial in jeder anderen Schicht dasselbe oder ein anderes in verschiedenen Paaren ist.

3. Bauelement nach Anspruch 1 oder 2, dadurch gekennzeichnet, daß der Schichtaufbau bis zu 500 Schichtenpaare, von dem Substrat sukzessiv ausgehend, aufweist.

4. Bauelement nach Anspruch 1, 2 oder 3, dadurch gekennzeichnet, daß das metallische Leitermaterial aus Titan, Zirkon und Niob ausgewählt ist.

5. Bauelement nach einem der vorhergehenden Ansprüche 1 bis 4, dadurch gekennzeichnet, daß das Halbleitermaterial in dem Schichtaufbau ausgewählt ist aus IV-, III/V- und II/VI-Halbleitermaterialien.

6. Bauelement nach Anspruch 5,
dadurch gekennzeichnet, daß
das IV-Halbleitermaterial aus Silicium, Germanium und Silicium-Germanium ausgewählt ist.

7. Bauelement nach Anspruch 1, 2 oder 3,
dadurch gekennzeichnet, daß
das Halbleitermaterial in dem Schichtaufbau Silicium ist, und daß das metallische Leitermaterial Titan ist.

8. Bauelement nach einem der vorhergehenden Ansprüche 1 bis 7,
dadurch gekennzeichnet, daß
die elektrischen Kontakte auf derselben Fläche des Schichtaufbaus vorgesehen sind.

9. Bauelement nach einem der vorhergehenden Ansprüche 1 bis 8,
dadurch gekennzeichnet, daß
das Bauelement als Strahlungsstärkesensor oder als Stellungssensor dient, oder als hochlinearer Positionssensor oder als stark nichtlinearer Positionssensor, oder als Sensor für elektromagnetische Strahlung, oder als Sensor für Teilchenstrahlung oder jede geeignete Kombination daraus.

10. Verfahren zum Herstellen eines Bauelements nach einem der vorhergehenden Ansprüche 1 bis 9,
dadurch gekennzeichnet, daß
die Mehrzahl abwechselnder Schichten aus metallischen Leitermaterialien und Halbleitermaterialien bei einer relativ niedrigen Temperatur auf dem Substrat niedergeschlagen werden.

**Revendications**

1. Un dispositif sensible au rayonnement qui comprend un substrat, une structure multicouche formée sur le substrat et une paire de contacts électriques pour le dispositif, l'un au moins de ces contacts étant formé sur la structure multicouche , cette structure multicouche consistant en un ensemble de paires de couches s'étendant en succession à partir du substrat, le matériau d'une couche dans chaque paire étant différent du matériau de l'autre couche de la paire, CARACTERISE EN CE QUE le substrat consiste en un matériau sélectionné parmi un isolant et des matériaux semiconducteurs de type n ou de type p, la première couche de chaque paire consiste en un matériau semiconducteur sélectionné parmi des matériaux semiconducteurs de type n, de type p et non dopés, et elle a une épaisseur dans la plage de 0,1 à 10 nanomètres, et la seconde couche de chaque paire consiste en un matériau conducteur métallique ayant une résistivité en volume inférieure à 200 $\mu\Omega$.cm, et elle a une épaisseur dans la plage de 0,1 à 8 nanomètres.

2. Dispositif selon la revendication 1, CARACTERISE EN CE QUE le matériau semiconducteur dans chaque première couche est le même ou est différent dans différentes paires, et le matériau conducteur métallique dans chaque seconde couche est le même ou différent dans différentes paires.

3. Le dispositif selon la revendication 1 ou 2, CARACTERISE EN CE QUE la structure multicouche comprend jusqu'à 500 paires de couches en succession à partir du substrat.

4. Dispositif selon la revendication 1 ou 2 ou 3, CARACTERISE EN CE QUE le matériau conducteur métallique est sélectionné parmi le titane, le zirconium et le niobium.

5. Dispositif selon l'une quelconque des revendications 1-4 précédentes, CARACTERISE EN CE QUE le matériau semiconducteur dans la structure multicouche est sélectionné parmi des matériaux des groupes suivants : Groupe IV, Groupe III-Groupe V, et Groupe II-Groupe VI.

6. Dispositif selon la revendication 5, CARACTERISE EN CE QUE le matériau du Groupe IV est sélectionné parmi le silicium, le germanium et le silicium-germanium.

7. Dispositif selon la revendication 1 ou 2 ou 3, CARACTERISE EN CE QUE le matériau semiconducteur dans la structure multicouche est du silicium et le matériau conducteur métallique est du titane.

8. Dispositif selon l'une quelconque des revendications 1-7 précédentes, CARACTERISE EN CE QUE les contacts électriques sont formés sur la même face de la structure multicouche.

9. Dispositif selon l'une quelconque des revendications 1-8 précédentes, CARACTERISE EN CE QUE ce dispositif remplit la fonction d'un capteur d'intensité de rayonnement ou d'un capteur de position, ou d'un capteur de position à linéarité élevée, ou d'un capteur de position fortement non linéaire, ou d'un capteur de rayonnement électromagnétique, ou d'un capteur de rayonnement de particules, ou de n'importe quelle combinaison appropriée de tels capteurs.

10. Un procédé de fabrication d'un dispositif selon l'une quelconquedes revendication 1-9, CARACTERISE EN CE QUE on dépose sur le substrat l'ensemble de couches alternées de matériaux conducteurs métalliques et semiconducteurs à une température relativement basse.

## FIG. 1

## FIG. 2

## FIG. 3

## FIG. 4